# EUROPEAN PATENT APPLICATION

(11) **EP 4 213 199 A1**
(43) Date of publication of application: **19.07.2023**
(21) Application number: 22151541.4
(22) Date of filing: 14.01.2022
(51) Int. Cl.: H01L 23/31, H01L 21/56, H01L 21/683, H01L 21/78, H01L 23/00

(54) **CHIP-SCALE PACKAGED VERTICAL SEMICONDUCTOR DEVICE**

(71) Applicant: Nexperia B.V., 6534 AB Nijmegen (NL)
(72) Inventor: Poelma, Rene, 6534 AB Nijmegen (NL); Bünning, Hartmut, 22529 Hamburg (DE); Berglund, Stefan, 22529 Hamburg (DE); Funke, Hans-Juergen, 22529 Hamburg (DE); Kuipers, Johannes Josinus, 6534 AB Nijmegen (NL); Stokkermans, Joep, 6534 AB Nijmegen (NL); Schnitt, Wolfgang, 22529 Hamburg (DE)
(74) Representative: Pjanovic, Ilija

(57) **Abstract**

Aspects of the present disclosure relate to a vertical semiconductor device. Aspects of the present disclosure further relate to a method for manufacturing such a vertical semiconductor device.

According to an aspect of the present disclosure, a vertical semiconductor device is provided that comprises a conformal coating arranged on its sidewalls. To prevent the conformal coating from covering unwanted areas, such as electrical terminals, a sacrificial layer is arranged prior to arranging the conformal coating. By removing the sacrificial layer, the conformal coating can be removed locally.

## Description

### FIELD

Aspects of the present disclosure relate to a chip-scale packaged vertical semiconductor device. Aspects of the present disclosure further relate to a method for manufacturing such a vertical semiconductor device. Within the context of the present disclosure, a vertical semiconductor device should be construed as a device comprising a semiconductor die, wherein the device comprises device terminals on opposite sides of the semiconductor die by which electrical signals can be supplied to and/or extracted from the device.

### BACKGROUND

Ideally, the mounting area required for mounting a vertical semiconductor device is only marginally larger than the cross-sectional area of the semiconductor die used in the vertical semiconductor device. As most of the semiconductor dies used for vertical semiconductor devices are at least locally electrically conductive, it is generally required to arrange some sort of electrical insulation on the sidewalls of the semiconductor die. Without such insulation, an electrical short may be generated when connecting the device terminals to an underlying carrier, such as a printed circuit board, using a conductive adhesive, solder or the like. More in particular, an electrical short could be created between a device terminal and a conductive layer of the semiconductor die that is exposed on the sidewall. For example, the semiconductor die may comprise a semiconductor body that comprises a semiconductor substrate and one or more epitaxial layers arranged on the semiconductor substrate. The semiconductor substrate and/or one or more of the epitaxial layers may be conductive. If an electrical connection would exist between such conductive layer and a device terminal, the circuit realized in the semiconductor device could malfunction.

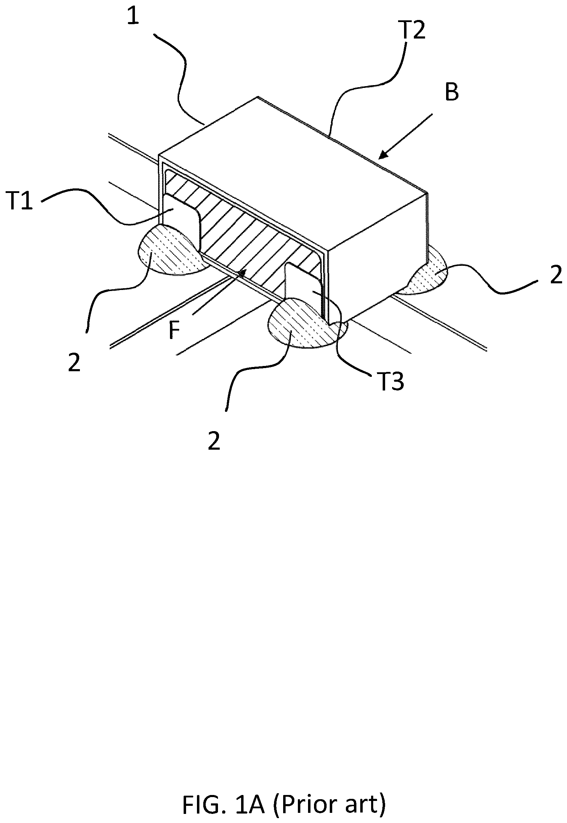

An example of the abovementioned situation is shown in figure 1A. Here, a bipolar transistor is shown having two terminals T1, T3 arranged at a frontside F of semiconductor die 1, and one terminal T2 arranged at backside B of semiconductor die 1. For example, terminals T1, T2, T3 may be connected to the base, emitter, and collector of the bipolar transistor, respectively. It should be noted that frontside F is typically provided with one or more electrically insulating layers covering the entire surface except at the positions of terminals T1, T3, whereas backside B is entirely covered by terminal T2.

The electrically insulating layers are applied prior to dicing the wafer. Consequently, after dicing the wafer, the sidewalls of semiconductor die 1 are exposed. In addition, the wording frontside and backside is arbitrary and may be reversed.

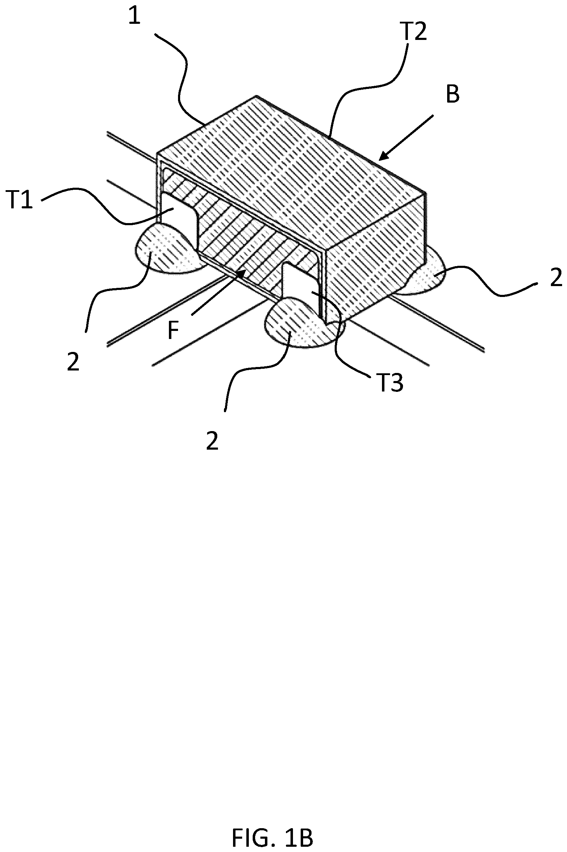

As shown in figure 1A, conductive glue 2 is touching both terminal T3 and a sidewall of semiconductor die 1. This latter sidewall corresponds in figure 1 to the sidewall of semiconductor die 1 that faces the carrier on which semiconductor die 1 is mounted. Typically, in this device, the substrate is at the same potential as terminal T2. Conductive glue 2 therefore creates an electrical short between terminals T3 and T2, and/or between T1 and T2.

In the art, a technique is known for obtaining an electrically insulating layer. For example, US2018233426A1 discloses a method for realizing 6-sided (6S) protection of a horizontal device by means of atomic layer deposition, ALD. During deposition, one side of the semiconductor die of the device is arranged on a carrier thereby preventing that the insulating layer would cover the device terminal arranged on that side. However, for vertical devices, a problem exists that the insulating layer would be deposited on the device terminal that is arranged on the other side of the semiconductor die. Accordingly, after deposition, the insulating layer needs to be removed from these terminals.

ALD is a highly conformal deposition technique by which very thin layers can be deposited at relatively low temperatures. The dielectric strength of ALD coatings is generally excellent, allowing a good electrical insulation around corners of the semiconductor die and on the sidewalls. Another advantage of ALD coatings is that they provide sufficient strength such that they remain attached to the semiconductor body and do not get damaged during handling or mounting of the semiconductor device.

The Applicant has found that it is very difficult to find a suitable insulating layer that on the one hand offers sufficient mechanical robustness, but which on the other hand can be removed from the device terminal(s) without too many difficulties. For example, although conformal layers obtained using ALD techniques show excellent mechanical robustness, they cannot be removed easily after deposition as these layers are chemically inert, at least to a large extent.

### SUMMARY

According to an aspect of the present disclosure, a method for manufacturing a vertical semiconductor device is provided in which the abovementioned problem does not occur or at least to a lesser extent. This method comprises providing a plurality of semiconductor dies arranged on a carrier, wherein the semiconductor dies have a first surface by which they are arranged on the carrier and a second surface opposite to the first surface. Each semiconductor die has a vertical device integrated thereon, wherein each vertical device comprises at least one first terminal arranged on the first surface, at least one second terminal arranged on the second surface, and sidewalls extending at least partially between the first and second surfaces. According to an aspect of the present disclosure, a sacrificial layer is provided on the second surface of the semiconductor dies, wherein at least one of the carrier and sacrificial layer at least partially covers the at least one first or second terminals, respectively, and comprises openings aligned with spaces between adjacent vertical devices.

The method further comprises arranging a conformal coating on the sacrificial layer and on the sidewalls of the plurality of vertical devices through the openings. Furthermore, the method comprises removing the conformal coating arranged on the sacrificial layer by removing the sacrificial layer.

According to an aspect of the present disclosure, the conformal coating that is arranged over the second terminals is removed not by chemically engaging the conformal coating directly, for example using etching techniques, but by removing the underlying sacrificial layer. In this manner, an insulating layer, namely the conformal coating, can be used that has excellent mechanical robustness even though this insulating layer by itself is substantially chemically inert. In general, the insulation layer will comprise multiple layers of different materials. As an example, the insulating layer will comprise an alternating stack of two different materials.

The plurality of semiconductor dies may correspond to a diced semiconductor wafer arranged on the carrier. The diced wafer may correspond to a partially-cut diced wafer, such as a half-cut diced wafer, in which the dies are still interconnected through a part of the semiconductor wafer. Alternatively, the diced wafer may correspond to a full-cut diced wafer in which the semiconductor dies have been physically separated. However, the present disclosure does not exclude embodiments in which the semiconductor dies have been arranged on the carrier without belonging to one wafer. For example, the semiconductor dies may have been arranged on the carrier using a pick-and-place apparatus.

Aspects of the present disclosure relate to embodiments in which the carrier is provided with openings and the sacrificial layer is not, to embodiments in which the sacrificial layer is provided with openings and the carrier is not, and to embodiments in which both the sacrificial layer and carrier are provided with openings. The openings mentioned here are configured to allow the conformal coating to be formed on the sacrificial layer and on the sidewalls of the semiconductor die.

The conformal coating may be arranged by performing atomic layer deposition. Performing atomic layer deposition may comprise using trimethylaluminum and water, and titanium tetrachloride and water, as precursor pairs. Using these precursor pairs, an alternating layer stack of Al₂O₃ and TiO₂ can be deposited.

The sacrificial layer may be arranged on the second surface of the semiconductor dies while still being interconnected in a wafer before dicing. For example, the sacrificial layer may be arranged on the second surface of the semiconductor dies, for example by means of deposition, spin-coating, evaporation, inkjet printing or stencil printing, while still being interconnected in a wafer and before arranging this wafer on the carrier. The sacrificial layer may be chosen from the group consisting of photoresist, polymers, thin metal layers, self-assembled monolayers, and/or combinations thereof. In addition, the method may comprise arranging and patterning a masking layer on the sacrificial layer and removing the sacrificial layer at least in regions outside the at least one second terminal. In these latter regions, the conformal coating will not be removed at a later stage as no sacrificial layer is present underneath the coating in these regions.

In some embodiments, the at least one second terminal may cover the entire second surface. In such cases, patterning the sacrificial layer may be omitted. If the sacrificial layer is arranged before dicing the wafer, the sidewalls of the dies after dicing will be substantially free of sacrificial layer. In addition, the wafer dicing process will itself result in openings being formed in the sacrificial layer if the sacrificial layer has not already been removed in the dicing lane.

In the above, a sacrificial layer is arranged that may extend, at least directly after deposition, also outside of the second terminals. Alternatively, the at least one second terminal can be formed using a metal layer stack that comprises a plurality of metal layers, wherein the sacrificial layer is formed by one or more metal layers that are arranged farthest from the second surface or a part thereof. This metal layer stack may for example comprise TiNiVAg, NiAu, Ni, Al, TiNiAg, AuNiAg, AuAsNiAg, and/or combinations thereof. By removing the one or more metal layers or a part thereof that form(s) the sacrificial layer, the conformal coating directly above the sacrificial layer will be removed, and the remaining metal layers will form the at least one second terminal. Furthermore, also in this case, the process of wafer dicing will cause openings to be formed in the sacrificial layer.

The sacrificial layer may be removed by ablating the sacrificial layer by means of photo-ablation. In this case, the sacrificial layer is illuminated using light having a suitable wavelength, pulse duration, and/or power. The energy contained in the light is transformed inside the sacrificial layer into heat. Due to the generated heat, the sacrificial layer will ablate violently thereby also breaking the conformal coating that the sacrificial layer is in contact with. Typically, the light is provided in a substantial uniform manner. In some embodiments, more in particular those in which the presence of the sacrificial layer does not influence the mechanical or electrical behavior of the semiconductor die, the light may not be provided uniformly. Rather the light may be patterned for example using a photomask or shadow mask and using standard exposure techniques. In this manner, the sacrificial layer can be removed locally.

The present disclosure does not exclude other means of removing the sacrificial layer provided that these means do not disturb or damage the other components of the semiconductor die. For example, removing the sacrificial layer may comprise providing a thermal shock to the sacrificial layer and conformal coating causing the conformal coating and sacrificial layer to mutually delaminate. The delaminated conformal coating, which as a result of applying the thermal shock may be in the form of flakes, is subsequently removed. The sacrificial layer is preferably a photo-sensitive layer, such as photoresist. In this case, the thermal shock can be provided by means of applying optical energy for example using a laser source. A cleaning step, such as cleaning plasma, can optionally be performed for removing the remaining sacrificial layer.

Alternatively, removing the sacrificial layer may comprise performing a grinding, dicing, cutting or other mechanical operation for removing the sacrificial layer and the conformal coating covering that layer. In this case, the conformal coating and sacrificial layer are physically engaged. A cleaning step, such as cleaning plasma, can optionally be performed for removing the remaining sacrificial layer.

Additionally, or alternatively, when the sacrificial layer is configured to be removed, it is preferred that the at least one second terminal covers the entire second surface of the semiconductor die.

Instead of the sacrificial layer being part of a metal stack or being deposited, the sacrificial layer may also be formed by attaching a first foil to the second surface of the semiconductor dies to at least partially cover the at least one second terminals of the vertical devices. The first foil can be provided with openings allowing the conformal coating to be arranged on the sidewalls of the plurality of vertical devices through the openings. When using the first foil as the sacrificial layer, the sacrificial layer may be removed by removing the first foil from the second surface. If the first foil comprises openings that are arranged on the at least one second terminal, conformal coating may still be present on the at least one second terminal after having removed the first foil. Provided sufficient terminal area remains uncovered by the conformal coating, the electrical characteristics of an electrical contact to such terminal is not or hardly affected.

In the above, the carrier may comprise a second foil. This second foil may be a dicing foil. Furthermore, the second foil may comprise a plurality of openings to allow the conformal coating to be formed on the sidewalls through the openings. After arranging the conformal coating, the semiconductor dies and the second foil can be separated. This may for example be done during a pick-and-place process in which the semiconductor dies are picked from the second foil. If the second foil comprises openings that are arranged on the at least one first terminal, conformal coating may still be present on the at least one first terminal after having removed the second foil. Provided sufficient terminal area remains uncovered by the conformal coating, the electrical characteristics of an electrical contact to such terminal is not or hardly affected.

The semiconductor device to be manufactured is preferably a chip-scale packaged semiconductor device.

Aspects of the present disclosure relate to various embodiments. For example, the carrier may comprise a dicing foil that is or is not provided with openings for allowing the conformal coating to be formed on the sidewalls of the semiconductor die. In these embodiments, the sacrificial layer may be formed as part of a metal stack, in which case openings in the sacrificial layer are formed as a result of wafer dicing, or the sacrificial layer is formed by means of deposition, in which case openings in the sacrificial layer are formed as a result of wafer dicing and/or as a result of optionally patterning the sacrificial layer, or the sacrificial layer is formed using a first foil that may or may not be provided with openings. Regardless the origin of the openings, the number of openings and the size and/or shape of the openings should be such that the precursors used for the conformal coating process are able to reach the sidewalls of the semiconductor die.

According to a further aspect of the present disclosure, a vertical semiconductor device is provided that comprises a semiconductor body on which a vertical device is integrated, wherein the semiconductor body comprises a first surface and a second surface and sidewalls extending between the first and second surfaces. The device further comprises at least one first terminal arranged and exposed on the first surface, at least one second terminal arranged and exposed on the second surface, and a conformal coating covering at least a part of the sidewalls to prevent a short-circuit from occurring between the at least one first and/or second terminals and the semiconductor body when mounting the semiconductor device on a carrier. Here, an exposed terminal refers to a terminal that can be physically contacted for establishing an electrical connection at the point of physical contact.

The at least one first terminal and/or second terminal is provided with a plurality of islands comprising the conformal coating. These islands are for example formed when a first or second foil is used that comprises openings formed over the first terminal and/or second terminal, respectively, as described above. The at least one first terminal and/or the at least second terminal may cover the first surface or the second surface, respectively, in its entirety.

The conformal coating may comprise a coating obtained by atomic layer deposition, and preferably comprising an alternating arrangement of Al₂O₃ and TiO₂ layers. This combination of layers provides protection against chemicals in the soldering and gluing process, as well as moisture and ionic contamination. In addition, it offers high electric breakdown strength and constitutes a good electrical insulator. The vertical device may be a device chosen from the group consisting of trench MOSFETs, planar MOSFETs, PN diodes, Schottky diodes, Zener diodes, and bipolar junction transistors. Additionally, or alternatively, the semiconductor body may comprise a conductive semiconductor substrate, such as an n-type or p-type doped silicon substrate. Additionally, or alternatively, the semiconductor device can be part of a chip-scale package.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1A illustrates a known vertical semiconductor device that is mounted to a carrier illustrating the problem of a short-circuit occurring between a device terminal and a sidewall of the semiconductor body of the semiconductor device;
Figure 1B illustrates a known vertical semiconductor device that is mounted to a carrier in accordance with an aspect of the present disclosure;
Figure 2A and 2B schematically illustrate two different embodiments of a vertical semiconductor device in accordance with an aspect of the present disclosure;
Figures 3-6 illustrate four methods for manufacturing a vertical semiconductor device in accordance with various aspects of the present disclosure.

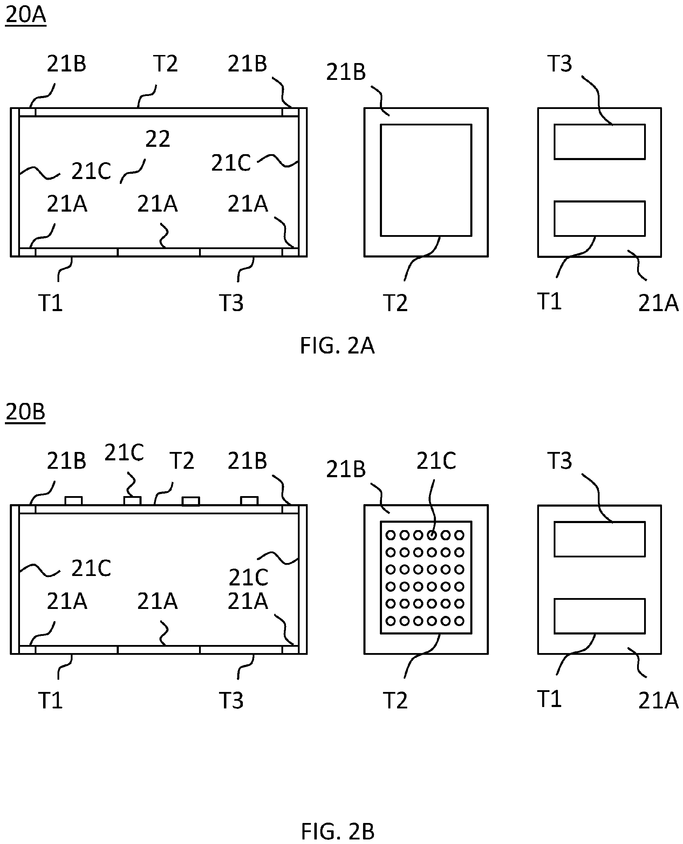

Figure 1B illustrates a vertical semiconductor device that is mounted to a carrier in accordance with an aspect of the present disclosure. Compared to the device shown in figure 1A, it can be observed that sidewalls of semiconductor die 1 are now covered by a conformal coating as indicated by the hashing, while terminals T1 and T3 are not covered by this coating. A more detailed explanation on this and other devices will be provided referring to figures 2A and 2B that schematically illustrate two different embodiments of a vertical semiconductor device in accordance with an aspect of the present disclosure.
Figure 2A illustrates an embodiment of a three-terminal vertical semiconductor device 20A in accordance with an aspect of the present disclosure. Device 20A comprises a conductive semiconductor body 22 having a first surface on which terminals T1, T3 are arranged, and a second surface on which a terminal T2 is arranged.

In the cross-sectional view on the left it can be observed that the sidewalls of semiconductor body 22 are covered with a conformal coating 21C. As shown in the center figure, a passivation layer 21A is arranged on a bottom surface adjacent terminals T1, T3. This passivation layer comprises one or more insulation layers, such as silicon oxide or silicon nitride, and may comprise conformal coating 21C as well. Similarly, on a front surface, a passivation layer 21B is arranged adjacent terminal T2. This passivation layer comprises one or more insulation layers, such as silicon oxide or silicon nitride, and may comprise conformal coating 21C as well. In some embodiments, during the manufacturing of the vertical semiconductor device, terminal T2 is pressed into the adhesive of the carrier film the wafer is arranged on. In such cases, the corner edge passivation 21B will not be obtained.

The top view in the center illustrates that terminal T2 is surrounded by passivation layer 21B. In some embodiments, terminal T2 is covered on a perimeter area thereof by passivation layer 21B, exposing only a center area of terminal T2. In other embodiments, terminal T2 covers the entire top surface of semiconductor body 22. In such embodiments, passivation layer 21B is absent.

The bottom view on the right illustrates that terminals T1, T3 are surrounded by passivation layer 21A. In some embodiments, terminals T1, T3 are covered on a perimeter area thereof by passivation layer 21A, exposing only a center area of terminals T1, T3.

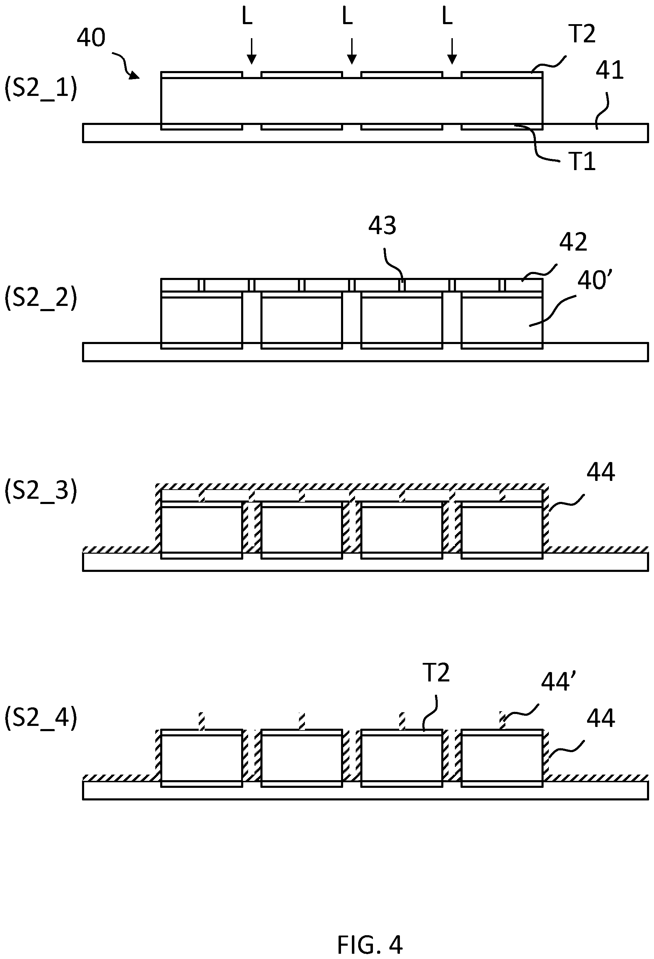

Figure 2B illustrates a further embodiment of a vertical semiconductor device 20B in accordance with an aspect of the present disclosure. Device 20B differs from device 20A in that terminal T2 is covered by small islands of conformal coating 21C. These islands may be the result of using the method of manufacturing a vertical semiconductor device as will be described in connection with figure 4.

Although figures 2A, 2B illustrate three-terminal devices, the present disclosure is not limited thereto. Devices having two or more than three terminals equally fall within the scope of this disclosure.

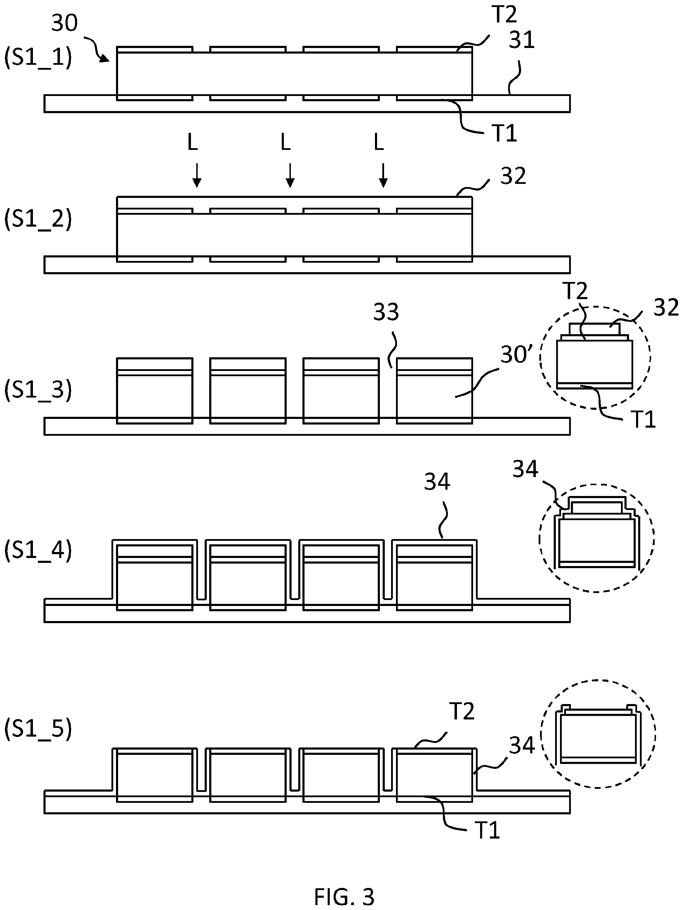

Figure 3 illustrates a first method for manufacturing a vertical semiconductor device in accordance with an aspect of the present disclosure. As a first step, shown as S1_1, a wafer 30 is provided in which a plurality of two-terminal devices is integrated. Each two-terminal device comprises a first terminal T1 arranged on a first surface of wafer 30 and a second terminal T2 arranged on a second surface of wafer 30. Each terminal T1, T2 is configured to cover an entire backside and frontside of the final device, respectively. Wafer 30 is arranged on a dicing foil 31 in such a manner that dicing foil 31 completely covers terminal T1. For example, terminal T1 can be pressed into dicing foil 31, as shown, or terminal T1 can fully lie against dicing foil 31.

As a next step, shown as S1_2, a sacrificial layer 32 is deposited on the second surface of wafer 30 thereby covering terminals T2. Sacrificial layer 32 may for example comprise photoresist, inks, pastes other materials with good heat absorption and a low evaporation point.

As a next step, shown as S1_3, wafer 30 is diced along dicing lines L. As a result of the dicing process, openings 33 are created in between the different semiconductor dies 30' that correspond to different devices.

In a next step shown as S1_4, a conformal coating 34 is applied using atomic layer deposition through openings 33. Here, an alternating stack of Al₂O₃ and TiO₂ layers is formed. In a next step shown as step S1_5, after depositing the alternating layer stack, sacrificial layer 32 is removed by means of photo-ablation. To this end, semiconductor dies 30' may be illuminated using light having a suitable wavelength such that sacrificial layer 32 absorbs the energy and heats up quickly. Finally, sacrificial layer 32 or a part thereof ablates from semiconductor dies 30' taking a part of conformal coating 34 with it. More in particular, the part of conformal coating 34 that is directly connected to sacrificial layer 32 will be removed together with at least a part of sacrificial layer 32 during the photo-ablation. For example, only a few nanometer of the sacrificial layer will be removed, e.g. ablated or evaporated, taking conformal coating 34 with it. After this step, the remaining part of sacrificial layer 32, if any, could be removed using a cleaning step for example using a plasma cleaning process.

As shown, after photo-ablation, sidewalls of semiconductor dies 30' are covered by conformal coating 34 while terminals T1, T2 are free of such coating.

In figure 3, as well as figures 4-6, terminal T2 is shown as entirely covering the second surface of wafer 30. However, the present disclosure is not limited thereto. For example, as shown in the hashed circles, embodiments are equally possible in which terminal T2 does not entirely cover the second surface of wafer 30. In this case, sacrificial layer 32 may be patterned, for example using lithography techniques. After performing ALD, conformal coating 34 will also cover part of terminal T2. As shown in the bottom circle, after having removed sacrificial layer 32, conformal coating 34 will cover a circumferential area of terminal T2.

Figure 4 illustrates a second method for manufacturing a vertical semiconductor device in accordance with an aspect of the present disclosure. As a first step, shown as S2_1, a wafer 40 arranged on dicing foil 41 is provided in which a plurality of two-terminal devices is integrated. This step is similar to step S1_1 shown in figure 3.

As a next step, shown as S2_2, wafer 40 is diced along dicing lanes L that are arranged on wafer 40. Furthermore, after dicing, a foil 42 is arranged on the second surface thereby covering terminals T2. Foil 42 comprises openings 43 that are not only arranged above the openings created during the dicing process but also above terminals T2.

As a next step, shown as S2_3, a conformal coating 44 is applied using atomic layer deposition through openings 43. Here, an alternating stack of Al₂O₃ and TiO₂ layers is formed. In a next step, shown as S2_4, after depositing the alternating layer stack, foil 42 is removed from wafer 40. By removing foil 42, coating 44 that is arranged on and in foil 42 is also removed. Compared to figure 3, step S1_5, it can be observed that islands 44' of conformal coating 44 may remain attached to terminal T2. It is further noted that the figures are not true to scale. For example, islands 44' of conformal coating 44 may have a diameter that is substantially larger than a height of conformal coating 44.

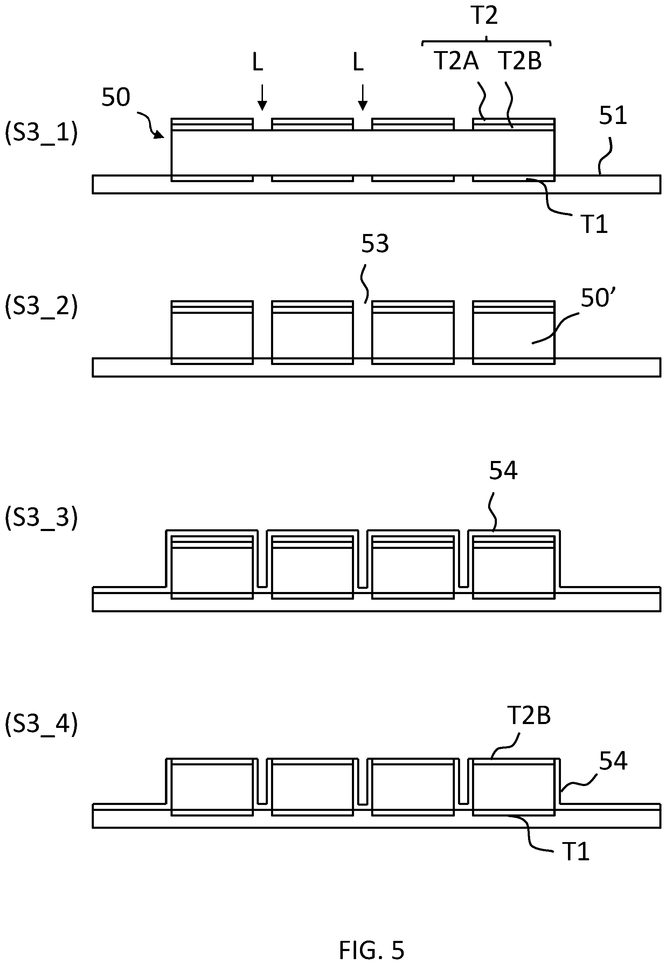

Figure 5 illustrates a third method for manufacturing a vertical semiconductor device in accordance with an aspect of the present disclosure. As a first step, shown as S3_1, a wafer 50 arranged on a dicing foil 51 is provided in which a plurality of two-terminal devices is integrated. This step differs from steps S1_1, S2_1 in that terminal T2 is formed using a metal layer stack comprising an upper part T2A and a lower part T2B. Here, upper part T2A or a part thereof forms a sacrificial layer. Lower part T2B may comprise for example TiNiVAg, TiNiAg, AuNiAg, AuAsNiAg, or combinations thereof, and upper part T2A may comprise for example Ag. In general, other metals also displaying low evaporation temperatures in combination with a high absorption of light energy for the wavelength of the light source used for the photo-ablation can be employed.

As a next step, shown as S3_2, wafer 50 is diced along dicing lanes L that are arranged on wafer 50. In between upper parts T2A openings 53 can be identified. In some embodiments, terminal T2 is formed to cover the entire second surface of wafer 50 prior to dicing. In such case, the dicing process will create openings 53 instead of the openings in the sacrificial layer already being present prior to dicing wafer 50.

As a next step, shown as S3_3, a conformal coating 54 is applied using atomic layer deposition through openings 53. Here, an alternating stack of Al₂O₃ and TiO₂ layers is formed. in a next step shown as S3_4, after depositing the alternating layer stack, upper part T2A or a part thereof is removed by means of photo-ablation. To this end, semiconductor dies 50' may be illuminated using light having a suitable wavelength such that upper part T2A absorbs the energy and heats up quickly. Finally, upper part T2A ablates from semiconductor dies 50' either partly or fully taking a part of conformal coating 54 with it. More in particular, the part of conformal coating 54 that is directly connected to upper part T2A will be removed together with at least a part of upper part T2A during the photo-ablation.

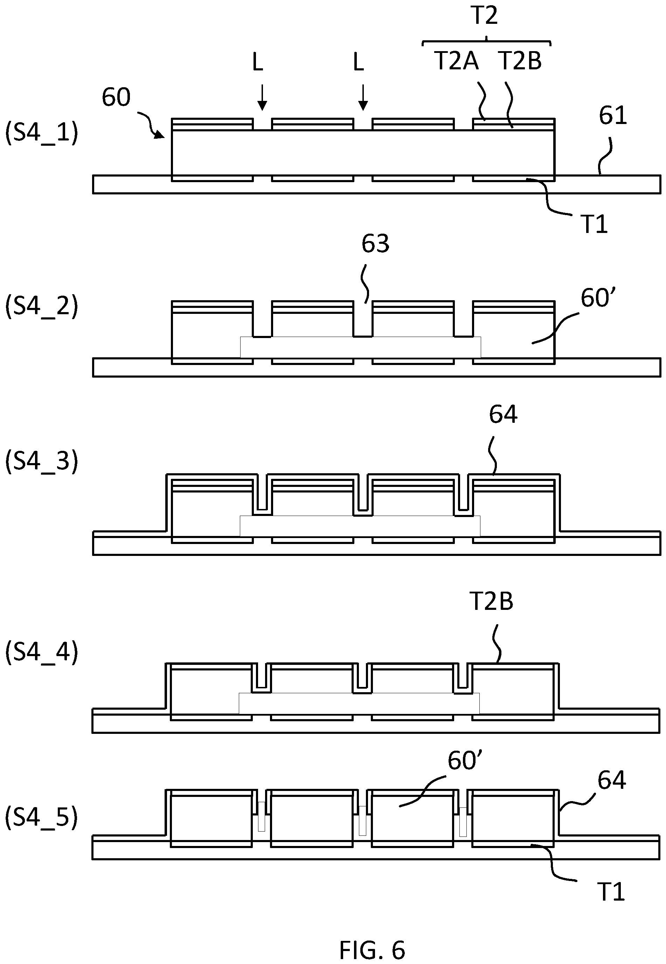

Figure 6 illustrates a fourth method for manufacturing a vertical semiconductor device in accordance with an aspect of the present disclosure. As a first step, shown as S4_1, a wafer 60 arranged on a dicing foil 61 is provided in which a plurality of two-terminal devices is integrated. This step is identical to step S3_1.

As a next step, shown as S4_2, wafer 60 is partially-cut diced, such as half-cut diced, along dicing lanes L that are arranged on wafer 60. Compared to step S3_2, the semiconductor dies remain attached to each other after dicing via a remaining part of wafer 60. In between upper parts T2A openings 63 can be identified. In some embodiments, terminal T2 is formed to cover the entire second surface of wafer 60 prior to dicing. In such case, the dicing process will create openings 63 instead of the openings in the sacrificial layer already being present prior to dicing wafer 60.

As a next step, shown as S4_3, a conformal coating 64 is applied using atomic layer deposition through openings 63. This step is identical to step S3_3. In a next step shown as S4_4, after depositing conformal coating 64, upper part T2A or a part thereof is removed by means of photo-ablation. To this end, semiconductor dies 60' may be illuminated using light having a suitable wavelength such that upper part T2A absorbs the energy and heats up quickly. Finally, upper part T2A ablates from semiconductor dies 60' either partly or fully taking a part of conformal coating 64 with it. More in particular, the part of conformal coating 64 that is directly connected to upper part T2A will be removed together with at least a part of upper part T6A during the photo-ablation.

As a final step, shown as S4_5, semiconductor dies 60' are fully separated, for example using a dry etch. In this method, there is less chance of contamination of the sidewalls during steps S4_3 and S4_4 as wafer 60 itself provides shielding for contaminants coming for instance from dicing foil 61. More in particular, this method can be used to prevent the glue layer of dicing foil 61 from contaminating the sidewalls of semiconductor dies 60' before atomic layer deposition.

In figures 3-6, a two-terminal device was discussed. However, the same method of manufacturing can be used for devices comprising more than two terminals. In addition, dicing foil 31, 41, 51,61 may also be provided with openings to allow conformal coating 34, 44, 54, 64 to be formed on the sidewalls of semiconductor dies 30', 40', 50', 60'.

In figures 3, 5 and 6, sacrificial layers 32, T2A are removed using photo-ablation. This light may be provided using a laser that scans over the surface of the diced wafer. Alternatively, a less focused light source may equally be used, for example a light source that illuminates the entire diced wafer at the same time or part of the sample using a shadow mask or other form of light patterning approach. Regardless the method of illumination, it is preferable that the sacrificial layer shows a much higher absorption of the optical energy than other components in the device. Accordingly, the material used as sacrificial layer for photo-ablation must be carefully chosen in connection with the light source that is going to be used. But differently, the sacrificial layer should have a relatively high specificity with respect to the absorption of energy from the external energy source when compared to other layers or components of the device. In this respect, it should be noted that according to another aspect of the present disclosure an energy source other than a light source can be used to cause the ablation of the sacrificial layer.

Furthermore, in figures 3-6, the entire first surface of wafer 30, 40, 50, 60 is covered by dicing foil 31, 41, 51, 61. Alternatively, a small space may exist between wafer 30, 40, 50, 60 and dicing foil 31, 41, 51, 61 in regions away from terminals T1. In such case, conformal coating may also be arranged on the first surface and adjacent to terminals T1.

In the above, the present invention has been described using detailed embodiments thereof. However, the present invention is not limited to these embodiments. Instead, various modifications are possible without departing from the scope of the present invention which is defined by the appended claims and their equivalents.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A method for manufacturing a vertical semiconductor device (20A, 20B), comprising:
providing a plurality of semiconductor dies (30', 40', 50', 60') arranged on a carrier, wherein the semiconductor dies have a first surface by which they are arranged on the carrier and a second surface opposite to the first surface, each semiconductor die having a vertical device integrated thereon, wherein each vertical device comprises at least one first terminal (T1) arranged on the first surface, at least one second terminal (T2) arranged on the second surface, and sidewalls extending between the first and second surfaces, wherein a sacrificial layer (32; 42; T2A) is provided on the second surface of the semiconductor dies, wherein at least one of the carrier and sacrificial layer at least partially covers the at least one first or second terminals, respectively, and comprises openings (33; 43; 53; 63) aligned with spaces between adjacent vertical devices;
arranging a conformal coating (34; 44; 54; 64) on the sacrificial layer and on the sidewalls of the plurality of vertical devices through the openings; and
removing the conformal coating arranged on the sacrificial layer by removing the sacrificial layer.

2. The method according to claim 1, wherein the plurality of semiconductor dies corresponds to a diced semiconductor wafer arranged on the carrier, wherein the diced wafer corresponds to a partially-cut diced wafer, such as a half-cut diced wafer, in which the dies are still interconnected through a part of the semiconductor wafer, or wherein the diced wafer corresponds to a full-cut diced wafer in which the semiconductor dies have been physically separated.

3. The method according to claim 1 or 2, wherein said arranging a conformal coating comprises performing atomic layer deposition, wherein said performing atomic layer deposition comprises using trimethylaluminum and water, and titanium tetrachloride and water as precursor pairs.

4. The method according to any of the previous claims, wherein said providing a plurality of semiconductor dies comprises arranging the sacrificial layer on the second surface of the semiconductor dies while still being interconnected in a wafer before dicing;
wherein said providing a plurality of semiconductor dies preferably comprises arranging the sacrificial layer on the second surface of the semiconductor dies while still being interconnected in a wafer and before arranging this wafer on the carrier.

5. The method according to claim 4, wherein said arranging the sacrificial layer on the second surface of the semiconductor dies comprises depositing a layer (32) on the second surface, said layer being chosen from the group consisting of photoresist, polymers, thin metal layers, self-assembled monolayers, and/or combinations thereof;
the method preferably further comprising arranging and patterning a masking layer on the sacrificial layer and removing the sacrificial layer at least in regions outside the at least one second terminal.

6. The method according to any of the claims 1-3, wherein the second terminal is formed using a metal layer stack comprising a plurality of metal layers, wherein the sacrificial layer (T2A) is formed by one or more metal layers that are arranged farthest from the second surface or a part thereof, wherein the metal layer stack preferably comprises TiNiVAg, NiAu, Ni, Al, TiNiAg, AuNiAg, AuAsNiAg and/or combinations thereof.

7. The method according to any of the claims 1-6, wherein said removing the sacrificial layer comprises ablating the sacrificial layer by means of photo-ablation.

8. The method according to any of the claims 1-6, wherein said removing the sacrificial layer comprises:
providing a thermal shock to the sacrificial layer and conformal coating causing the conformal coating and sacrificial layer to mutually delaminate; and
removing the delaminated conformal coating;
wherein the sacrificial layer is preferably a photo-sensitive layer, such as photoresist, and wherein the thermal shock is preferably provided by means of applying optical energy for example using a laser source;
the method optionally comprising performing a cleaning step for removing the remaining sacrificial layer.

9. The method according to any of the claims 1-6, wherein said removing the sacrificial layer comprises performing a grinding, dicing, cutting or other mechanical operation for removing the sacrificial layer and the conformal coating covering that layer by physically engaging the conformal coating and sacrificial layer, the method optionally comprising performing a cleaning step for removing the remaining sacrificial layer.

10. The method according to any of the claims 1-3, wherein said providing a plurality of semiconductor dies comprises attaching a first foil (42) as the sacrificial layer to the second surface of the semiconductor dies thereby at least partially covering the at least one second terminals of the vertical devices, wherein the first foil is preferably provided with openings (43) allowing the conformal coating to be arranged on the sidewalls of the plurality of vertical devices through the openings, and/or wherein said removing the sacrificial layer comprising removing the first foil from the second surface.

11. The method according to any of the previous claims, wherein the carrier comprises a second foil, wherein the second foil is preferably a dicing foil (31; 41; 51; 61), and/or wherein the second foil preferably comprises a plurality of openings to allow the conformal coating to be formed on the sidewalls through the openings.

12. The method according to any of the previous claims, wherein the semiconductor device to be manufactured is part of a chip-scale package.

13. A vertical semiconductor device (20A; 20B), comprising:
a semiconductor body (22) on which a vertical device is integrated, said semiconductor body comprising a first surface and a second surface and sidewalls extending between the first and second surfaces;
at least one first terminal (T1, T3) arranged and exposed on the first surface, and at least one second terminal (T2) arranged and exposed on the second surface; and
a conformal coating (21C) covering at least a part of the sidewalls to prevent a short-circuit from occurring between the at least one first and/or second terminals and the semiconductor body when mounting the semiconductor device on a carrier.

14. The device according to claim 13, wherein the at least one first terminal and/or second terminal is provided with a plurality of islands (21C) comprising said conformal coating, and/or wherein the conformal coating comprises a coating obtained by atomic layer deposition, preferably comprising an alternating arrangement of Al₂O₃ and TiO₂ layers.

15. The device according to any of the claims 13-14, wherein the device is a device chosen from the group consisting of trench MOSFETs, planar MOSFETs, PN diodes, Schottky diodes, Zener diodes, and bipolar junction transistors, and/or wherein the semiconductor body comprises a conductive semiconductor substrate, such as an n-type or p-type doped silicon substrate, and/or wherein the semiconductor device is a chip-scale package.
